# EUROPEAN PATENT APPLICATION

(11) **EP 4 818 736 A1**
(43) Date of publication of application: **07.10.2026**
(21) Application number: 24899523.5
(22) Date of filing: 30.10.2024
(51) Int. Cl.: G01R 35/00, G01R 19/10

(54) **VOLTAGE RATIO OVER-RANGE SELF-CALIBRATION METHOD, COMPUTER DEVICE, AND STORAGE MEDIUM**

(30) Priority: 04.12.2023 CN 202311643657
(71) Applicant: Tunkia Co., Ltd., Changsha, Hunan 410000 (CN)
(72) Inventor: ZHOU, Xinhua, Changsha, Hunan 410000 (CN)
(74) Representative: Santarelli
(86) International application number: PCT/CN2024/128422
(87) International publication number: WO 2025/118880

(57) **Abstract**

The present invention relates to a voltage ratio over-range self-calibration method, a computer device, and a storage medium. The method can be used for calibrating measurement errors of voltage ratio of a voltage ratio instrument, wherein the voltage ratio instrument is provided with a voltage source with multiple ranges, which is capable of outputting at least two channels of voltage signal simultaneously, measurement circuits coupled to output channels of the two channels of voltage signal, and a microprocessor.

## Description

### Technical field

The present application relates to the field of electrical measurement. Specifically, the present application relates to a voltage ratio over-range self-calibration method, a computer device, and a storage medium.

### Background of the Invention

Voltage ratio apparatuses are an important type of device in the field of electrical measurement. For example, the accuracy of the measurement values of a voltage ratio apparatus is of great importance, when tracing the measurement values of a DC voltage ratio instrument, the way of differential measurement and the way of voltage comparison are generally used. The way of differential measurement involves measuring the voltage across a differential measurement bridge arm between a standard equipment and a device under test (DUT), and tracing the measurement values of the DUT to the standard equipment, which can be classified as the compensation method and the difference value method. The compensation method involves series-connecting a compensation power supply and a null indicator on a differential measurement bridge arm, manually adjusting the compensation power supply until the null indicator indicates zero, and measuring the voltage across the differential measurement bridge arm. The difference value method involves series-connecting a voltmeter on a differential measurement bridge arm and directly measuring the voltage across the differential measurement bridge arm. However, in precision measurements, the null indicator as used in the compensation method is of high sensitivity, thus the null indicator is highly susceptible to interference from manual adjustments and other human factors, which affects the accuracy of traceability. Whilst in the difference value method, the differential current flowing through the differential measurement bridge arm significantly affects the accuracy of traceability. Therefore, neither the compensation method nor the difference value method is suitable for tracing measurement values of a high-precision DC voltage ratio instrument. The way of voltage comparison involves directly measuring the output voltages of a standard equipment and a DUT, tracing the measurement values of the DUT to the standard equipment. Since the input impedance of a digital voltmeter can affect the voltage division ratio of the standard equipment or the DUT, and the two digital voltmeters as used for measuring the standard equipment and the DUT are of different systematic measurement errors. Therefore, when tracing measurement values of a high-precision DC voltage ratio instrument, the accuracy of the final result of traceability by the way of voltage comparison is relatively low and cannot meet the requirements. Additionally, the way of differential measurement and the way of voltage comparison are generally used in the case that the standard equipment and DUT output analog signals. With the development of digital technology, many DC voltage ratio apparatuses now output digital signals compliant with specific protocols instead of analog signals. For traceability of such DC voltage ratio apparatuses, the existing way of differential measurement and way of voltage comparison are not applicable.

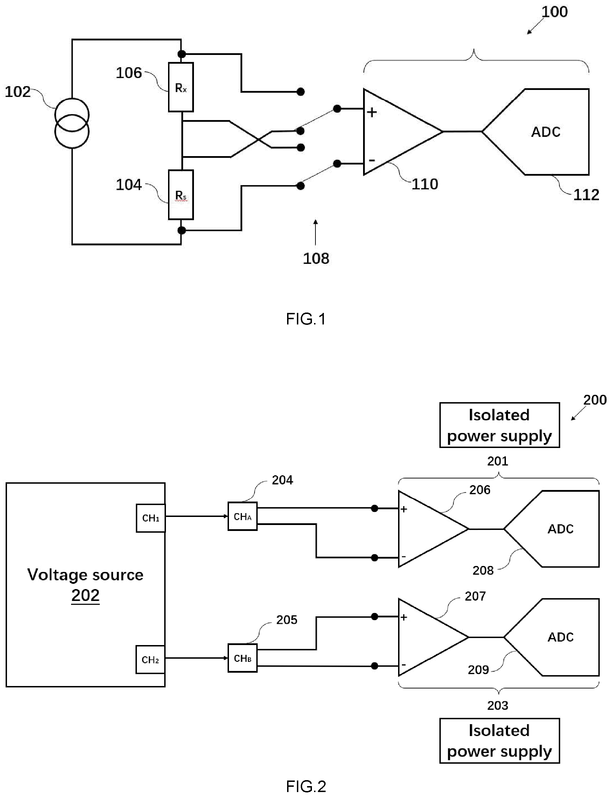

One approach for precisely measuring voltage ratios using digital technology is to utilize a resistance bridge measurement circuit to measure resistance ratios. FIG. 1 is a schematic drawing of a resistance bridge measurement circuit 100 coupled to two resistors Rₛ 104, Rₓ 106 in the prior art. The resistance bridge measurement circuit 100 comprises a current source 102, a switch 108, and a measurement circuit 101. The measurement circuit 101 can comprise an amplifier 110 and an analog-to-digital converter (ADC) 112. The resistor Rₛ 104 is a standard resistor or reference resistor, and the resistor Rₓ 106 can be a sensor resistor Rₓ 106. The reference resistor Rₛ 104 and the sensor resistor Rₓ 106 are connected in series. When the current source 102 supplies a current to the circuit, the current flows through both the reference resistor Rₛ 104 and the sensor resistor Rₓ 106. As the current flows through each of the resistors Rₛ 104 and Rₓ 106, a voltage is generated across each resistor, which is proportional to the resistance of each resistor. The amplifier 110 and the ADC 112 sequentially measure the voltage across each resistor. For example, the voltage across Rₛ 104 is Uₛ, and the voltage across Rₓ 106 is Uₓ. Since only one voltage can be measured at one time, the switch 108 is set to couple the amplifier 110 and the ADC 112 among the two resistors Rₛ 104 and Rₓ 106. Once the voltages across each resistor Rₛ 104 and Rₓ 106 have been measured, the voltages can be converted into a voltage ratio, which corresponds to the resistance ratio: Uₓ/Uₛ = Rₓ / Rₛ.

Through the measurement method of resistance ratio, a relatively high measurement accuracy within a certain resistance ratio range can be achieved. However, when the resistance ratio is out of range, the measurement accuracy of the voltage ratio degrades due to over-range of the voltage ratio. Additionally, due to the inherent characteristics of the resistors, the accuracy of the measurement method of resistance ratio is typically an annual index, meaning that the resistors must be calibrated regularly to meet the requirements on measurement accuracy. However, calibrating the resistors is a task that requires specialized skills and is highly timeconsuming.

Therefore, it is required a voltage ratio measuring and calibrating method that is more accurate and more efficient to meet the calibration accuracy and efficiency requirements for voltage ratio traceability.

### Summary of the Invention

The present application aims to solve the problem that a voltage ratio instrument is difficult to calibrate accurately and efficiently in the case that voltage ratios are over-range.

According to a first aspect, an embodiment of the present application provides a voltage ratio over-range self-calibration method for calibrating voltage ratio errors of a voltage ratio instrument, wherein the voltage ratio instrument is provided with a voltage source with multiple ranges which is capable of outputting two channels of voltage signal simultaneously, measurement circuits coupled to output channels of the two channels of voltage signal, and a microprocessor. The method comprises: step S1, outputting two channels of voltage signal with the voltage source at each output range, with each channel of voltage signal setting to either the amplitude of a range or the amplitude of a lower range adjacent to the range, generating a combination of signals at the same range or a combination of signals at adjacent ranges with a voltage ratio that meets the requirement of the linearity range of the measurement circuits; step S2, for each set of combination of signals at the same range and each set of combination of signals at adjacent ranges, measuring two channels of voltage signal of the combination of signals at the same range and the combination of signals at adjacent ranges respectively by the measurement circuits and obtaining values of error of the voltage ratio thereof, storing the values of error of the voltage ratio in a memory as calibration parameters of voltage ratios at the same range and calibration parameters of voltage ratios at adjacent ranges; step S3, invoking the calibration parameters of voltage ratios at the same range and the calibration parameters of voltage ratios at adjacent ranges stored in the memory, calculating the cumulative errors of voltage ratios spanning more than two ranges compared to a foundational range of the voltage source as calibration parameters of voltage ratios at cross ranges, which include calibration parameters in the case that voltage ratios exceed the linearity range of the measurement circuit; step S4, storing the calibration parameters of voltage ratios at cross ranges in the memory; step S5, invoking the calibration parameters of voltage ratios at the same range, the calibration parameters of voltage ratios at adjacent ranges and the calibration parameters of voltage ratios at cross ranges stored in the memory to calibrate the voltage ratio instrument.

According to a preferable embodiment of the first aspect of the present application, the voltage source is capable of outputting voltage signals {U₁, U₂,...Uᵢ ...Uⱼ ...Uₘ₋₁, Uₘ} with the number of ranges of m, wherein m≥3 and m is an integer, 1<i<j≤m and i and j are both integers, and in the step S2, when the combination of channel signals at the same range and the combination of channel signals at adjacent ranges are set to U₁/U₁, U₁/U₂, U₂/U₁, U₂/U₂, U₂/U₃, U₃/U₂, U₃/U₃...Uᵢ/Uᵢ, Uᵢ/Uᵢ₊₁, Uᵢ₊₁/Uᵢ, Uᵢ₊₁/Uᵢ₊₁...Uₘ₋₁/Uₘ₋₁, Uₘ₋₁/Uₘ, Uₘ/Uₘ₋₁, Uₘ/Uₘ respectively, the calibration parameters of voltage ratios at the same range and the calibration parameters of voltage ratios at adjacent ranges k(U₁, U₁), k(U₁, U₂), k(U₂, U₁), k(U₂, U₂), k(U₂, U₃), k(U₃, U₂), k(U₃, U₃)...k(Uᵢ, Uᵢ), k(Uᵢ, Uᵢ₊₁), k(Uᵢ₊₁, Uᵢ), k(Uᵢ₊₁, Uᵢ₊₁)...k(Uₘ₋₁, Uₘ₋₁), k(Uₘ₋₁, Uₘ), k(Uₘ, Uₘ₋₁), k(Uₘ, Uₘ) are measured respectively.

According to a preferable embodiment of the first aspect of the present application, in the step S3, the calibration parameters of voltage ratios at cross ranges can be calculated through the calibration parameters of voltage ratios at the same range and the calibration parameters of voltage ratios at adjacent ranges by Formula (I) and Formula (II), wherein the calibration parameters of voltage ratios at cross ranges include the calibration parameters in the case that the voltage ratios are over-range. $k \left(Uj,U1\right) = {\sum }_{x = 1}^{j - 1} k \left(Ux+1,Ux\right)$ Formula (I) $k \left(U1,Uj\right) = {\sum }_{x = 1}^{j - 1} k \left(Ux,Ux+1\right)$ Formula (II)

According to a preferable embodiment of the first aspect of the present application, the ratio of voltage amplitudes of the adjacent ranges of the voltage source is in the range of 0.1-10, preferably in the range of 0.4 to 2.5.

According to a preferable embodiment of the first aspect of the present application, the measurement circuits comprise a first measurement circuit and a second measurement circuit respectively coupled to the output channels of the two channels of voltage signal, and the first measurement circuit and the second measurement circuit are both composed of an adjustable gain amplifier and an ADC.

According to a preferable embodiment of the first aspect of the present application, the ADCs used in the first measurement circuit and the second measurement circuit are substantially identical.

According to a second aspect, an embodiment of the present application provides a computer device comprising a processor and a memory storing a computer program, the processor implements any one of the above methods provided according to embodiments of the first aspect of the present application when executing the computer program.

According to a third aspect, an embodiment of the present application provides a computer-readable storage medium having a computer program stored thereon, the computer program implements any one of the above methods provided according to embodiments of the first aspect of the present application when executed by a processor.

The voltage ratio over-range self-calibration method provided by the present application is capable of solving the calibration difficulties of voltage ratio instruments in the case that voltage ratios exceed the linearity range. Compared with traditional calibration methods, the voltage ratio over-range self-calibration method provided by the present application not only improves calibration accuracy but also saves calibration time.

### Brief Description of the Drawings

One or more embodiments of the present application are exemplarily described through the accompanying drawings corresponding to the embodiments. These exemplary illustrations do not constitute limitations on the embodiments. Elements with the same reference numerals in the accompanying drawings indicate similar elements, the figures in the accompanying drawings do not constitute limitations on scale, unless otherwise specified.
FIG. 1 is a schematic drawing of a resistance bridge measurement circuit in the prior art.
FIG. 2 is a schematic drawing of a voltage ratio measurement circuit suitable for applying the voltage ratio over-range self-calibration method provided according to an embodiment of the present application.
FIG. 3 is a block diagram of a system including voltage ratio measurement circuits provided according to an embodiment of the present application.
FIG. 4 is a schematic drawing of an application environment for the voltage ratio over-range self-calibration method provided according to an embodiment of the present application.
FIG. 5 is a schematic drawing of a calibration environment for the voltage ratio over-range self-calibration method provided according to an embodiment of the present application.
FIG. 6 is a flow chart of the voltage ratio over-range self-calibration method provided according to an embodiment of the present application.
FIG. 7 is a matrix diagram of the voltage ratio calibration parameters with voltage ratios under different combinations of range for the voltage ratio over-range self-calibration method provided according to an embodiment of the present application.

### Detailed Description of Embodiments

In order to make the objectives, technical solutions and advantages of the present application more apparent, the present application is further described in detail below in combination with the accompanying drawings and embodiments. It should be understood that the specific embodiments described herein are only used to explain the present application without limiting it.

It should be noted that, if there is no conflict, various features in the embodiments of the present application can be combined with one another, and they are all within the scope of the present application. Additionally, although functional modules are separated in the schematic drawings, and logical sequences are shown in the flow chart, the steps shown or described can be executed in a manner different from the module separation in the schematic drawings or the sequences in the flow chart in certain cases.

Unless otherwise defined, all of the technical and scientific terms used in this specification have the same meanings as generally understood by those skilled in the art to which the present application pertains. The terms used in the specification of the present application are intended solely for the purpose of describing specific embodiments without limitation of the present application. The term "and/or" as used in this specification includes any and all combinations of one or more related listed items.

The technical solutions in the embodiments of the present application will be described apparently and completely below in combination with the accompanying drawings thereof, so as to make the objectives and advantages of the present application more apparent. Obviously, the embodiments as described are a part of the embodiments of the present application, but not exhaustive embodiments.

Referring to FIG. 2, a schematic drawing is shown of a voltage ratio measurement circuit 200 that is suitable for applying the voltage ratio over-range self-calibration method provided according to an embodiment of the present application. The voltage ratio measurement circuit 200 comprises a voltage source 202, a first measurement circuit 201, and a second measurement circuit 203. The voltage source 202 comprises at least two output channels CH₁ and CH₂. The first measurement circuit 201 and the second measurement circuit 203 comprise corresponding input signal channels CH_{A} and CH_{B}. The voltage source 202 is configured to provide voltage signals to the first measurement circuit 201 and the second measurement circuit 203. The first measurement circuit 201 and the second measurement circuit 203 are substantially identical circuits. Specifically, the first measurement circuit 201 and the second measurement circuit 203 comprise an amplifier 206, ADC 208 and an amplifier 207, ADC 209, respectively, with the ADCs 208, 209 being substantially identical. Wherein, the amplifiers 206, 207 are both adjustable gain amplifiers, which are coupled to the ADCs 208, 209, respectively. The first measurement circuit 201 and the second measurement circuit 203 are electrically isolated from each other, e.g., powered via isolated power supplies.

In one or more embodiments, the two output channels CH₁, CH₂ of the voltage source 202 simultaneously output voltage signals U₁, U₂ based on the signal requirements of the input signal channel CH_{A} of the first measurement circuit 201 and the input signal channel CH_{B} of the second measurement circuit 203, and the amplifiers 206, 207 adjust gain coefficients respectively according to instructions. After the voltage signals U₁, U₂ are amplified according to the gain coefficients of the amplifiers 206 and 207 respectively, they are converted into digital signals via ADCs 208, 209. In a microprocessor (not shown), the digital signals converted by ADCs 208, 209 can be expressed as a voltage ratio, which corresponds to the ratio of the voltage signals U₁, U₂ output by the two output channels CH₁, CH₂ of the voltage source 202.

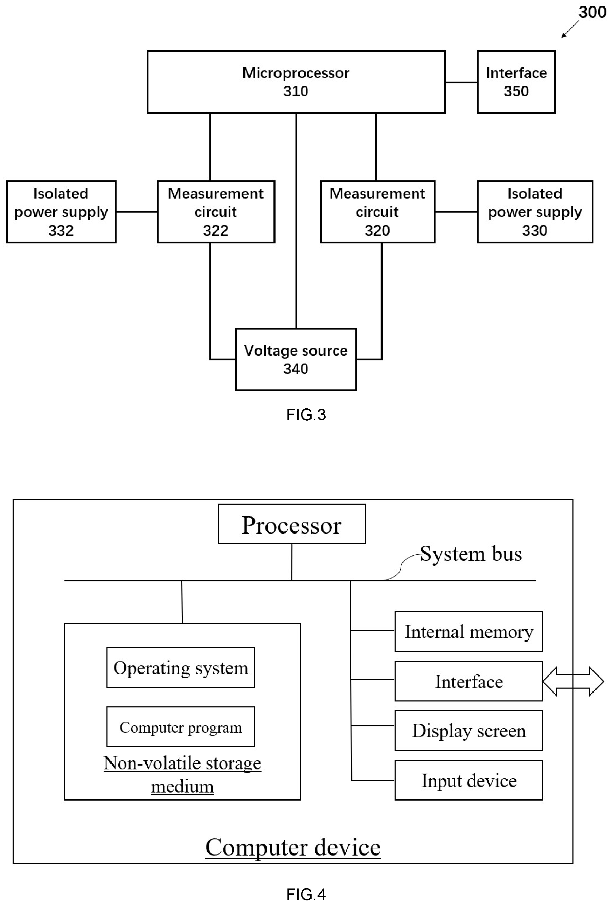

Referring to FIG. 3, a block diagram is shown of a system 300 including voltage ratio measurement circuits provided according to an embodiment of the present application. The components in the system 300 of FIG. 3 which are similar to those in the voltage ratio measurement circuit 200 of FIG. 2 work in a similar manner. Therefore, for the sake of brevity, structures and functions thereof are not repeatedly described. The system 300 comprises a microprocessor 310 coupled to two measurement circuits 320, 322, a voltage source 340, and an interface 350 for externally controlling the microprocessor 310. The measurement circuits 320 and 322 can comprise adjustable gain amplifiers and ADCs, and the ADCs of the measurement circuits 320, 322 are substantially identical. In some embodiments, the measurement circuits 320, 322 can be coupled to corresponding isolated power supplies 330, 332. The isolated power supplies 330, 332 can be used to power the corresponding measurement circuits 320, 322 when performing measurements. In particular, the interface 350 can receive instructions from the outside, so that the microprocessor 310 is capable of controlling the amplitude ratio of the voltage signal input from the voltage source 340 to the input signal channel of the measurement circuits 320, 322. The microprocessor 310 can also be used to control the range of the voltage signal output by the voltage source 340, and to obtain a voltage ratio from the voltage measurement performed by the measurement circuits 320, 322 and further calculate the error of the voltage ratio.

Referring to FIG. 4, a schematic drawing is shown of an application environment for the voltage ratio over-range self-calibration method provided according to an embodiment of the present application. In the application environment shown in FIG. 4, the computer device can be a server, and its internal structure block can be as shown in FIG. 4. The computer device comprises a processor, a memory, an interface, and a database connected via a system bus. Wherein, the processor of the computer device is used to provide computing and controlling capabilities. The memory of the computer device comprises a non-volatile storage medium and an internal memory. The non-volatile storage medium stores an operating system, a computer program, and a database. The internal memory provides an environment for the operation of the operating system and the computer program in the non-volatile storage medium. The database of the computer device is used to store data of the voltage ratio over-range self-calibration method. The interface of the computer device is used to communicate with an external terminal. When the computer program is executed by the processor, the voltage ratio over-range self-calibration method can be implemented.

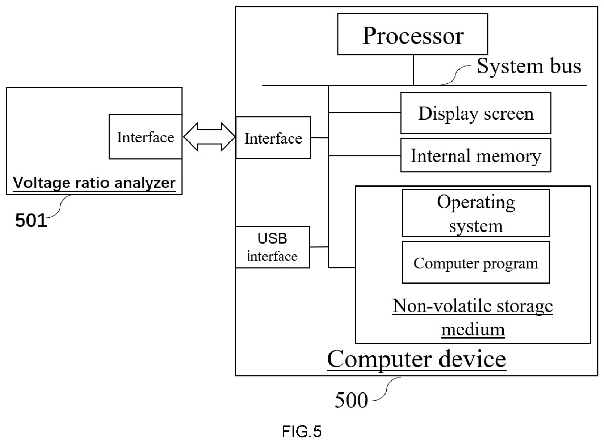

Referring to FIG. 5, a schematic drawing is shown of a calibration environment for the voltage ratio over-range self-calibration method provided according to an embodiment of the present application. In the calibration environment shown in FIG. 5, the voltage ratio over-range self-calibration method as described in the present application is executed by a computer device 500 to realize automatic calibration of a voltage ratio instrument. In the embodiment shown in FIG. 5, the voltage ratio instrument is a voltage ratio analyzer 501 developed by the applicant. The computer device 500 is similar to the computer device shown in the above-mentioned FIG. 4, and will not be described in detail here.

### Concept of the invention

The basic principle of the present invention is based on an important discovery: when the ratio of the input voltage signals of the two measurement circuits shown in FIG. 2 is maintained in the range of 0.1 to 10, preferably in the range of 0.4 to 2.5, the ADCs of the measurement circuit can maintain in good linearity. For the measurement circuit shown in FIG. 2, the ratio between the amplitude Uₙ of the n^{th} range and the amplitude Uₙ₊₁ of the (n+1)^{th} range of the voltage source can be configured to be 0.4 or 0.5. When the voltage source is set to output the n^{th} range of voltage (with the amplitude Uₙ), the output channels CH₁ and CH₂ of the voltage source can be controlled by instructions so that the value of signal input to the channel CH_{A} of the measurement circuit is equal to the amplitude Uₙ of the n^{th} range or the amplitude Uₙ₊₁ of the (n+1)^{th} range of the voltage source, and the value of signal input to the channel CH_{B} of the measurement circuit is equal to the amplitude Uₙ of the n^{th} range or the amplitude Uₙ₊₁ of the (n+1)^{th} range of the voltage source. Such a configuration makes the ratio of Uₙ₊₁/Uₙ or Uₙ/Uₙ₊₁ satisfy the linearity of the measurement circuit to maintain in consistent with condition that the voltage ratio is 1 (i.e., Uₙ/Uₙ), and the linearity error of measurement is very small.

The input signal of the channel CH_{A} is represented as S_{A}, and the input signal of the channel CH_{B} is represented as S_{B}. The effective value of the signal S_{A} is labeled as U_{A}, the effective value of the signal S_{B} is labeled as U_{B}, and the voltage ratio error between the signal S_{A} and the signal S_{B} is represented as k(U_{A}, U_{B}). As mentioned above, when the voltage source is set to output voltage of the n^{th} range, the effective value of the signal S_{A} is set to the amplitude Uₙ of the n^{th} range of the voltage source or a middle value equal to the amplitude Uₙ₊₁ of the (n+1)^{th} range of the voltage source, and the measured values of the signal are represented as S_{A}(Uₙ) and S_{A}(Uₙ₊₁) respectively; similarly, the effective value of the signal S_{B} is set to the amplitude Uₙ of the n^{th} range of the voltage source or the middle value Uₙ₊₁, and the measured values of the signal are represented as S_{B}(Uₙ) and S_{B}(Uₙ₊₁) respectively. When the signal combinations of adjacent ranges are selected in this way, the voltage ratio errors k(Uₙ, Uₙ), k(Uₙ, Uₙ₊₁), k(Uₙ₊₁, Uₙ), k(Uₙ₊₁, Uₙ₊₁) between the combinations of channel signals (S_{A}, S_{B}) form a second-order matrix as shown in Table 1.

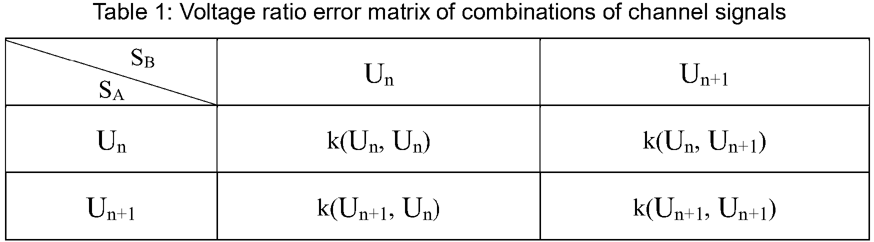

k(Uₙ, Uₙ) can be calculated by Formula (1):
$k \left({U}_{n}, {U}_{n}\right) = {S}_{B} \left({U}_{n}\right) / {S}_{A} \left({U}_{n}\right) - 1 ;$ Formula (1)

k(Uₙ₊₁, Uₙ₊₁) can be calculated by Formula (2):
$k \left({U}_{n + 1}, {U}_{n + 1}\right) = {S}_{B} \left({U}_{n + 1}\right) / {S}_{A} \left({U}_{n + 1}\right) - 1 ;$ Formula (2)

k(Uₙ, Uₙ₊₁) and k(Uₙ₊₁, Uₙ) can be calculated by Formula (3) and Formula (4) respectively:
$k \left({U}_{n}, {U}_{n + 1}\right) = {S}_{B} \left({U}_{n + 1}\right) / \left[A*{S}_{A}\left({U}_{n}\right)\right] - 1 ;$ Formula (3)
$k \left({U}_{n + 1}, {U}_{n}\right) = A * {S}_{B} \left({U}_{n}\right) / {S}_{A} \left({U}_{n + 1}\right) - 1 ;$ Formula (4)

Wherein, the coefficient A in Formula (3) and Formula (4) which is related to the gain of the measurement circuit can be given by Uₙ₊₁/ Uₙ.

In actual operation, after the voltage ratio errors k(Uₙ, Uₙ), k(Uₙ, Uₙ₊₁), k(Uₙ₊₁, Uₙ), k(Uₙ₊₁, Uₙ₊₁) are measured by the measurement circuit, the values of the errors can be used as calibration parameters of an instrument for measuring voltage ratios (such as a voltage ratio analyzer). Assuming that the measurement circuit can maintain in good linearity, when the voltage ratio between the channel signal S_{A} and the channel signal S_{B} exceeds the linearity range (that is, the voltage ratio is over-range), the voltage ratio errors within the linearity range of the measurement circuit can be accumulated and calculated in the manner of tracing back step by step to obtain the calibration parameters in the case that the voltage ratio is over-range.

The process of obtaining the calibration parameters in the case that the voltage ratios span more than two ranges by accumulating the voltage ratio errors is described below. Assuming that the voltage source is capable of outputting voltage signals {U₁, U₂,...Uᵢ...Uⱼ...Uₘ₋₁, Uₘ} with a total number of ranges of m, wherein m≥3 and m is an integer, 1<i<j≤m and i and j are both integers, and the voltage ratio of amplitude Uᵢ/Uᵢ₊₁ or Uᵢ₊₁/Uᵢ of the ranges between any adjacent ranges (i.e. the i^{th} range and the (i+1)^{th} range) of the voltage source is within the linearity range of the measurement circuit. Firstly, when the combination of channel signals S_{A}/S_{B} are set to U₁/U₁, U₁/U₂, U₂/U₁, U₂/U₂, U₂/U₃, U₃/U₂, U₃/U₃...Uᵢ/Uᵢ, Uᵢ/Uᵢ₊₁, Uᵢ₊₁/Uᵢ, Uᵢ₊₁/Uᵢ₊₁...Uₘ₋₁/Uₘ₋₁, Uₘ₋₁/Uₘ, Uₘ/Uₘ₋₁, Uₘ/Uₘ respectively, the voltage ratio errors k(U₁, U₁), k(U₁, U₂), k(U₂, U₁), k(U₂, U₂), k(U₂, U₃), k(U₃, U₂), k(U₃, U₃)...k(Uᵢ, Uᵢ), k(Uᵢ, Uᵢ₊₁), k(Uᵢ₊₁, Uᵢ), k(Uᵢ₊₁, Uᵢ₊₁)...k(Uₘ₋₁, Uₘ₋₁), k(Uₘ₋₁, Uₘ), k(Uₘ, Uₘ₋₁), k(Uₘ, Uₘ) of the combination of channel signals S_{A}/S_{B} are measured respectively by the measuring circuit; then, when the voltage ratios span more than two ranges (up to the number of m-1 ranges), the cumulative errors are calculated by the following Formula (I) and Formula (II): $k \left(Uj,U1\right) = {\sum }_{x = 1}^{j - 1} k \left(Ux+1,Ux\right)$ Formula (I) $k \left(U1,Uj\right) = {\sum }_{x = 1}^{j - 1} k \left(Ux,Ux+1\right)$ Formula (II)

When the voltage ratios span more than two ranges, the cumulative errors as calculated by the above Formula (I) and Formula (II) can be used as the calibration parameters in the case that the voltage ratios are over-range.

For example, the voltage source is usually set to be able to output voltage signals with more than five ranges, and the amplitude ratio between adjacent ranges is usually set to 0.4 or 0.5. The typical voltage output ranges are set to {5V, 2V, 1V, 500mV, 200mV, 100mV, 50mV}. If the voltage ratio between the combination of channel signals S_{A}/S_{B} of the measurement circuit is the ratio of the amplitude of the maximum range to that of the minimum range(5V/50mV=100), which exceeds the linearity range of the measurement circuit, the calibration parameter in the case that the voltage ratio is over-range to 5V/50mV=100 can be obtained by accumulating the voltage ratio errors measured by setting the combination of channel signals S_{A}/S_{B} to 5V/5V, 5V/2V, 2V/1V, 1V/500mV, 500mV/200mV, 200mV/100mV, 100mV/50mV.

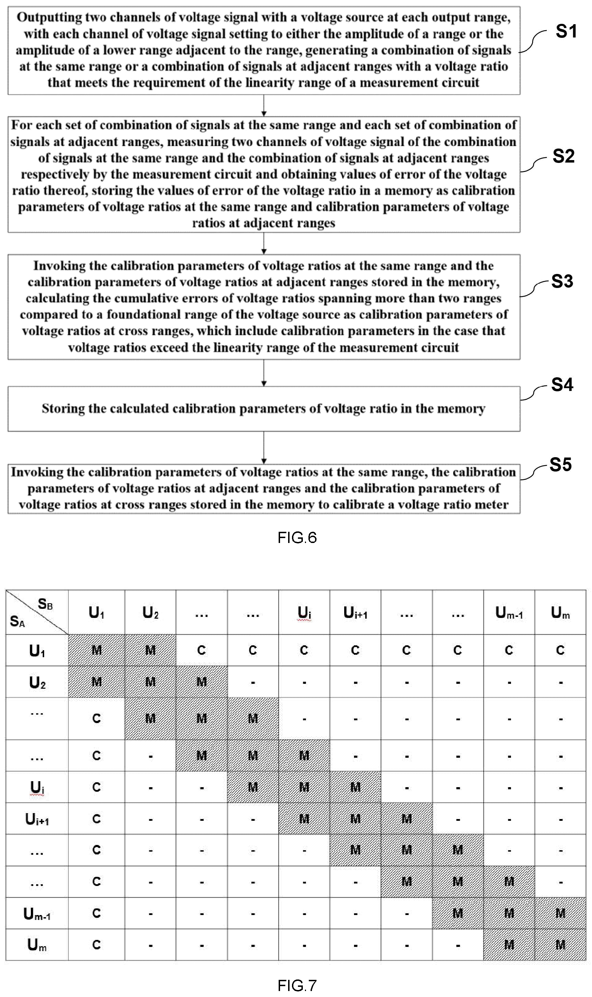

FIG. 6 provides a flow chart of the voltage ratio over-range self-calibration method according to an embodiment of the present application. The method comprises: step S1, outputting two channels of voltage signal with a voltage source at each output range, with each channel of voltage signal setting to either the amplitude of the range or the amplitude of a lower range adjacent to the range, generating a combination of signals at the same range or a combination of signals at adjacent ranges with a voltage ratio that meets the requirement of the linearity range of a measurement circuit; step S2, for each set of combination of signals at the same range and each set of combination of signals at adjacent ranges, measuring two channels of voltage signal of the combination of signals at the same range and the combination of signals at adjacent ranges respectively by the measurement circuit and obtaining values of error of the voltage ratio thereof, storing the values of error of the voltage ratio in a memory as calibration parameters of voltage ratios at the same range and calibration parameters of voltage ratios at adjacent ranges; step S3, invoking the calibration parameters of voltage ratios at the same range and the calibration parameters of voltage ratios at adjacent ranges stored in the memory, calculating the cumulative errors of voltage ratios spanning more than two ranges compared to a foundational range of the voltage source as calibration parameters of voltage ratios at cross ranges, which include calibration parameters in the case that voltage ratios exceed the linearity range of the measurement circuit; step S4, storing the calibration parameters of voltage ratios at cross ranges in the memory; step S5, invoking the calibration parameters of voltage ratios at the same range, the calibration parameters of voltage ratios at adjacent ranges and the calibration parameters of voltage ratios at cross ranges stored in the memory to calibrate the voltage ratio instrument.

Referring to FIG. 7, a matrix diagram is shown of the voltage ratio calibration parameters of the voltage ratio over-range self-calibration method provided according to an embodiment of the present application with the voltage ratio in a combination of different ranges. Wherein, m is the number of ranges of the voltage source, m≥3 and m is an integer; Uᵢ is the voltage amplitude of the i^{th} range of the voltage source, 1≤i< m and i is an integer. S_{A} or S_{B} represents the input signal of the channel CH_{A} or the channel CH_{B} in the measurement circuit shown in FIG.2. The range combinations of voltage ratios in the matrix diagram include combinations of the same range, combinations of adjacent ranges, and combinations of cross ranges. The combinations of the same range and combinations of adjacent ranges identified by the letter M in the matrix diagram indicate that the voltage ratio calibration parameters between the signal S_{A} and the signal S_{B} are the parameters directly measured in the above step S2, i.e., the calibration parameters of voltage ratios at the same range and the calibration parameters of voltage ratios at adjacent ranges; the combinations of cross ranges identified by the letter C in the matrix diagram indicate that the voltage ratio calibration parameters between the signal S_{A} and the signal S_{B} are the parameters calculated in the above step S3 according to Formula (I) and Formula (II), i.e., the calibration parameters of voltage ratios at cross ranges. Among them, the combinations of cross ranges involve the case that voltage ratios exceed the linearity range of the measurement circuit. The calibration parameters of voltage ratios at the same range, the calibration parameters of voltage ratios at adjacent ranges and the calibration parameters of voltage ratios at cross ranges listed in the matrix diagram in FIG.7 can be stored in a memory. When calibrating the voltage ratio instrument, these voltage ratio calibration parameters stored in the memory can be invoked to achieve high-precision and efficient calibration.

It can be understood by those skilled in the art that all or part of the processes in realizing the method of the above embodiments can be completed by instructing relevant hardware through a computer program. The computer program can be stored in a non-volatile computer-readable device. When the computer program is executed, the processes of the embodiments of the above method can be included. Among them, any reference to a memory, storage, database or other medium used in the embodiments provided in the present can include non-volatile and/or volatile memory. Non-volatile memory may include read-only memory (ROM), programmable ROM (PROM), electrically programmable ROM (EPROM), electrically erasable programmable ROM (EEPROM) or flash memory. Volatile memory may include random access memory (RAM) or external cache memory. By way of illustration rather than limitation, RAM is available in many forms, such as static RAM (SRAM), dynamic RAM (DRAM), synchronous DRAM (SDRAM), double data rate SDRAM (DDRSDRAM), enhanced SDRAM (ESDRAM), synchronous link (Synchlink) DRAM (SLDRAM), memory bus (Rambus) direct RAM (RDRAM), direct memory bus dynamic RAM (DRDRAM), and memory bus dynamic RAM (RDRAM), etc.

The technical features of the above embodiments can be combined in any way. For sake of brevity of the description, not all of the possible combinations of the technical features in the above embodiments are described. However, as long as there is no contradiction in the combination of these technical features, all possible combinations should be considered to be within the scope of the specification.

It should be noted that the above embodiments are only used to illustrate the technical solutions of the present application without limitation. The above embodiments or the technical features in different embodiments can be further combined within the concept of the present application, the steps can be implemented in any order, and there are many other variations regarding different aspects of the application as described above, which are not provided in detail for the sake of brevity. Although the present application has been described in detail with reference to the foregoing embodiments, it will be understood by those of ordinary skills in the art that the technical solutions described in the foregoing embodiments can still be modified, alternatively, some of the technical features therein can be equivalently substituted. These modifications or substitutions do not make the essence of the corresponding technical solution depart from the scope of technical solutions of the embodiments of the present application. For those of ordinary skills in the art, various modifications and variations can be made without departing from the concept of the present application, and these are all within the protection scope of the present application.

## Claims

1. A voltage ratio over-range self-calibration method for calibrating voltage ratio errors of a voltage ratio instrument, wherein the voltage ratio instrument is provided with a voltage source with multiple ranges which is capable of outputting two channels of voltage signal simultaneously, measurement circuits coupled to output channels of the two channels of voltage signal, and a microprocessor, **characterized in that**, the method comprising:
step S1, outputting two channels of voltage signal with the voltage source at each output range, with each channel of voltage signal setting to either the amplitude of a range or the amplitude of a lower range adjacent to the range, generating a combination of signals at the same range or a combination of signals at adjacent ranges with a voltage ratio that meets the requirement of the linearity range of a measurement circuit;
step S2, for each set of combination of signals at the same range and each set of combination of signals at adjacent ranges, measuring two channels of voltage signal of the combination of signals respectively by the measurement circuits and obtaining values of error of the voltage ratio thereof, storing the values of error of the voltage ratio in a memory as calibration parameters of voltage ratios at the same range and calibration parameters of voltage ratios at adjacent ranges;
step S3, invoking the calibration parameters of voltage ratios at the same range and the calibration parameters of voltage ratios at adjacent ranges stored in the memory, calculating the cumulative errors of voltage ratios spanning more than two ranges compared to a foundational range of the voltage source as calibration parameters of voltage ratios at cross ranges, which include calibration parameters in the case that voltage ratios exceed the linearity range of the measurement circuit;
step S4, storing the calibration parameters of voltage ratios at cross ranges in the memory;
step S5, invoking the calibration parameters of voltage ratios at the same range, the calibration parameters of voltage ratios at adjacent ranges and the calibration parameters of voltage ratios at cross ranges stored in the memory to calibrate the voltage ratio instrument.

2. The voltage ratio over-range self-calibration method according to claim 1, **characterized in that**, the voltage source is capable of outputting voltage signals {U₁, U₂,...Uᵢ ...Uⱼ ...Uₘ₋₁, Uₘ} with the number of ranges of m, wherein m≥3 and m is an integer, 1<i<j≤m and i and j are both integers, and in the step S2, when the combination of channel signals at the same range and the combination of channel signals at adjacent ranges are set to U₁/U₁, U₁/U₂, U₂/U₁, U₂/U₂, U₂/U₃, U₃/U₂, U₃/U₃...Uᵢ/Uᵢ, Uᵢ/Uᵢ₊₁, Uᵢ₊₁/Uᵢ, Uᵢ₊₁/Uᵢ₊₁...Uₘ₋₁/Uₘ₋₁, Uₘ₋₁/Uₘ, Uₘ/Uₘ₋₁, Uₘ/Uₘ respectively, the calibration parameters of voltage ratios at the same range and the calibration parameters of voltage ratios at adjacent ranges k(U₁, U₁), k(U₁, U₂), k(U₂, U₁), k(U₂, U₂), k(U₂, U₃), k(U₃, U₂), k(U₃, U₃)...k(Uᵢ, Uᵢ), k(Uᵢ, Uᵢ₊₁), k(Uᵢ₊₁, Uᵢ), k(Uᵢ₊₁, Uᵢ₊₁)...k(Uₘ₋₁, Uₘ₋₁), k(Uₘ₋₁, Uₘ), k(Uₘ, Uₘ₋₁), k(Uₘ, Uₘ) are measured respectively.

3. The voltage ratio over-range self-calibration method according to claim 2, **characterized in that**, in the step S3, the calibration parameters of voltage ratios at cross ranges can be calculated through the calibration parameters of voltage ratios at the same range and the calibration parameters of voltage ratios at adjacent ranges by Formula (I) and Formula (II): $k \left(Uj,U1\right) = {\sum }_{x = 1}^{j - 1} k \left(Ux+1,Ux\right)$ Formula (I) $k \left(U1,Uj\right) = {\sum }_{x = 1}^{j - 1} k \left(Ux,Ux+1\right)$ Formula (II) wherein, the calibration parameters of voltage ratios at cross ranges include the calibration parameters in the case that the voltage ratios are over-range.

4. The voltage ratio over-range self-calibration method according to claim 1, **characterized in that**, the ratio of voltage amplitudes of the adjacent ranges of the voltage source is in the range of 0.1-10.

5. The voltage ratio over-range self-calibration method according to claim 4, **characterized in that**, the ratio of voltage amplitudes of the adjacent ranges of the voltage source is in the range of 0.4 to 2.5.

6. The voltage ratio over-range self-calibration method according to claim 5, **characterized in that**, the ratio of voltage amplitudes of the adjacent ranges of the voltage source is set to 0.4 or 0.5.

7. The voltage ratio over-range self-calibration method according to claim 1, **characterized in that**, the measurement circuits comprise a first measurement circuit and a second measurement circuit respectively coupled to the output channels of the two channels of voltage signal, and the first measurement circuit and the second measurement circuit are both composed of an adjustable gain amplifier and an ADC.

8. The voltage ratio over-range self-calibration method according to claim 1, **characterized in that**, the ADCs used in the first measurement circuit and the second measurement circuit are substantially identical.

9. A computer device comprising a processor and a memory storing a computer program, **characterized in that**, the processor implements the method according to any one of claims 1 to 8 when executing the computer program.

10. A computer-readable storage medium having a computer program stored thereon, **characterized in that**, the computer program implements the method according to any one of claims 1 to 8 when executed by a processor.

## Amended claims

### Amended claims under Art. 19.1 PCT

1. A voltage ratio over-range self-calibration method for calibrating voltage ratio errors of a voltage ratio instrument, wherein the voltage ratio instrument is provided with a voltage source with multiple ranges which is capable of outputting two channels of voltage signal simultaneously, measurement circuits coupled to output channels of the two channels of voltage signal, and a microprocessor, the voltage source is capable of outputting voltage signals {U₁, U₂,...Uᵢ ...Uⱼ ...Uₘ₋₁, Uₘ} with the number of ranges of m, wherein m≥3 and m is an integer, 1<i<j≤m and i and j are both integers, **characterized in that**, the method comprising:
step S1, outputting two channels of voltage signal with the voltage source at each output range, with each channel of voltage signal setting to either the amplitude of a range or the amplitude of a lower range adjacent to the range, generating a combination of signals at the same range or a combination of signals at adjacent ranges with a voltage ratio that meets the requirement of the linearity range of a measurement circuit;
step S2, for each set of combination of signals at the same range and each set of combination of signals at adjacent ranges U₁/U₁, U₁/U₂, U₂/U₁, U₂/U₂, U₂/U₃, U₃/U₂, U₃/U₃...Uᵢ/Uᵢ, Uᵢ/Uᵢ₊₁, Uᵢ₊₁/Uᵢ, Uᵢ₊₁/Uᵢ₊₁...Uₘ₋₁/Uₘ₋₁, Uₘ₋₁/Uₘ, Uₘ/Uₘ₋₁, Uₘ/Uₘ, measuring two channels of voltage signal of the combination of signals respectively by the measurement circuits and obtaining values of error of the voltage ratio thereof by Formula (1) - Formula (4) below, $k \left({U}_{n}, {U}_{n}\right) = {S}_{B} \left({U}_{n}\right) / {S}_{A} \left({U}_{n}\right) - 1 ,$ Formula (1) $k \left({U}_{n + 1}, {U}_{n + 1}\right) = {S}_{B} \left({U}_{n + 1}\right) / {S}_{A} \left({U}_{n + 1}\right) - 1 ,$ Formula (2) $k \left({U}_{n}, {U}_{n + 1}\right) = {S}_{B} \left({U}_{n + 1}\right) / \left[A*{S}_{A}\left({U}_{n}\right)\right] - 1 ,$ Formula (3) $k \left({U}_{n + 1}, {U}_{n}\right) = A * {S}_{B} \left({U}_{n}\right) / {S}_{A} \left({U}_{n + 1}\right) - 1 ,$ Formula (4)
wherein 1≤n≤m-1 and n is an integer, k(Uₙ, Uₙ) and k(Uₙ₊₁, Uₙ₊₁) represent the values of error of the voltage ratio at the same range, k(Uₙ, Uₙ₊₁) and k(Uₙ₊₁, Uₙ) represent the values of error of the voltage ratio at adjacent ranges, S_{A}(Uₙ) and S_{B}(Uₙ) represent respectively the measurement values of signals when the effective value of the input signals S_{A}, S_{B} of the channels CH_{A}, CH_{B} of the voltage ratio instrument is set to the amplitude Uₙ of the n^{th} range of the voltage source, S_{A}(Uₙ₊₁) and S_{B}(Uₙ₊₁) represent respectively the measurement values of signals when the effective value of the input signals S_{A}, S_{B} of the channels CH_{A}, CH_{B} of the voltage ratio instrument is set to the amplitude Uₙ₊₁ of the (n+1)^{th} range of the voltage source, A is a coefficient related to the gain of the measurement circuit, storing the values of error of the voltage ratio in a memory as calibration parameters of voltage ratios at the same range and calibration parameters of voltage ratios at adjacent ranges k(U₁, U₁), k(U₁, U₂), k(U₂, U₁), k(U₂, U₂), k(U₂, U₃), k(U₃, U₂), k(U₃, U₃)...k(Uᵢ, Uᵢ), k(Uᵢ, Uᵢ₊₁), k(Uᵢ₊₁, Uᵢ), k(Uᵢ₊₁, Uᵢ₊₁)...k(Uₘ₋₁, Uₘ₋₁), k(Uₘ₋₁, Uₘ), k(Uₘ, Uₘ₋₁), k(Uₘ, Uₘ);
step S3, invoking the calibration parameters of voltage ratios at adjacent ranges stored in the memory, calculating the cumulative errors of voltage ratios spanning more than two ranges compared to a foundational range of the voltage source as calibration parameters of voltage ratios at cross ranges by Formula (I) and Formula (II) below, $k \left(Uj,U1\right) = {\sum }_{x = 1}^{j - 1} k \left(Ux+1,Ux\right)$ Formula (I) $k \left(U1,Uj\right) = {\sum }_{x = 1}^{j - 1} k \left(Ux,Ux+1\right)$ Formula (II)
wherein the calibration parameters of voltage ratios at cross ranges include calibration parameters in the case that voltage ratios are over-range;
step S4, storing the calibration parameters of voltage ratios at cross ranges in the memory;
step S5, invoking the calibration parameters of voltage ratios at the same range, the calibration parameters of voltage ratios at adjacent ranges and the calibration parameters of voltage ratios at cross ranges stored in the memory to calibrate the voltage ratio instrument.

2. The voltage ratio over-range self-calibration method according to claim 1, **characterized in that**, the ratio of voltage amplitudes of the adjacent ranges of the voltage source is in the range of 0.1~10.

3. The voltage ratio over-range self-calibration method according to claim 2, **characterized in that**, the ratio of voltage amplitudes of the adjacent ranges of the voltage source is in the range of 0.4 to 2.5.

4. The voltage ratio over-range self-calibration method according to claim 3, **characterized in that**, the ratio of voltage amplitudes of the adjacent ranges of the voltage source is set to 0.4 or 0.5.

5. The voltage ratio over-range self-calibration method according to claim 1, **characterized in that**, the measurement circuits comprise a first measurement circuit and a second measurement circuit respectively coupled to the output channels of the two channels of voltage signal, and the first measurement circuit and the second measurement circuit are both composed of an adjustable gain amplifier and an ADC.

6. The voltage ratio over-range self-calibration method according to claim 5, **characterized in that**, the ADCs used in the first measurement circuit and the second measurement circuit are substantially identical.

7. A computer device comprising a processor and a memory storing a computer program, **characterized in that**, the processor implements the method according to any one of claims 1 to 6 when executing the computer program.

8. A computer-readable storage medium having a computer program stored thereon, **characterized in that**, the computer program implements the method according to any one of claims 1 to 6 when executed by a processor.
